# EUROPEAN PATENT APPLICATION

(11) **EP 4 220 302 A1**
(43) Date of publication of application: **02.08.2023**
(21) Application number: 22153692.3
(22) Date of filing: 27.01.2022
(51) Int. Cl.: G03F 7/20, H01L 21/683, H01L 21/687

(54) **SYSTEM FOR HOLDING AN OBJECT IN A SEMICONDUCTOR MANUFACTURING PROCESS, LITHOGRAPHIC APPARATUS PROVIDED WITH SAID SYSTEM AND METHOD**

(71) Applicant: ASML Netherlands B.V., 5500 AH Veldhoven (NL)
(72) Inventor: DONDERS, Sjoerd, Nicolaas, Lambertus, 5500 AH Veldhoven (NL); VAN DE KERKHOF, Marcus, Adrianus, 5500 AH Veldhoven (NL); VAN DONGEN, Paul, 5500 AH Veldhoven (NL)
(74) Representative: ASML Netherlands B.V.

(57) **Abstract**

The disclosure provides a system for holding an object in a semiconductor manufacturing process, the system comprising: at least one pad of dry adhesive material (100), the material having a structured surface, the surface having a structuring comprising a plurality of projections (110) each having a stem and an end face (120) facing away from the surface, said end face of the projections being adapted to grip the object (150), the system being adapted to release the object by movement of the object (150) with respect to the dry adhesive material (100) or vice versa.

## Description

### FIELD

The present invention relates to a system for holding an object in a semiconductor manufacturing process, a lithographic apparatus provided with said system and a method of holding an object in a semiconductor manufacturing process. The object may be, for instance, a wafer, substrate or reticle. The object may be held in, for instance, a lithographic apparatus or a measurement device. The system may be, or may be part of, a wafer clamp, wafer handler, reticle handler, reticle clamp, or positioning module. The system may be part of a substrate or reticle support system for a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features that are patterned on the substrate. Typical wavelengths currently in use are 365 nm (i-line), 248 nm (KrF), 193 nm (ArF) and 13.5 nm (EUV). A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

At such short wavelengths, transport to and from storage locations and precise positioning of the patterning device, reticle, or substrate within the lithographic apparatus is essential. A substrate handler transports the substrates from a storage to a substrate table. In a conventional lithography apparatus, the Substrate to be exposed may be supported by a substrate holder which in turn is supported by a substrate table. The substrate holder is often a flat rigid disc corresponding in size and shape to the substrate (although it may have a different size or shape). It has an array of projections, referred to as burls or pimples, projecting from at least one side. The Substrate holder may have an array of projections on two opposite sides. In this case, when the substrate holder is placed on the substrate table, the main body of the substrate holder is held a small distance above the substrate table while the ends of the burls on one side of the substrate holder lie on the surface of the substrate table. Similarly, when the substrate rests on the top of the burls on the opposite side of the substrate holder, the substrate is spaced apart from the main body of the substrate holder. One purpose of the burls is to help prevent a particle (for instance contamination such as a dust particle) which might be present on either the substrate table or substrate holder from distorting the substrate holder or the substrate. Since the total surface area of the burls is only a small fraction of the total area of the substrate or substrate holder, it is highly probable that any particle will lie between burls and its presence will have no effect.

Due to the high accelerations experienced by the substrate in use of a high-throughput lithographic apparatus, it is not sufficient to allow the substrate simply to rest on the burls of the substrate holder. The substrate is clamped in place. In addition to holding the substrate, the clamping force may also flatten the substrate to match the substrate holder. Substrates, such as wafers, may seem flat at first glance, but are often not sufficiently flat for lithography. In combination, tops of the burls on the substrate holder provide a plane which is sufficiently flat.

One of the following methods of clamping the substrate may typically be applied: vacuum clamping and electrostatic clamping. In vacuum clamping, the space between the substrate holder and substrate and optionally between the substrate table and substrate holder are partially evacuated so that the substrate is held in place by the higher pressure of gas or liquid above it. Vacuum clamping however may not be feasible where the beam path and/or the environment near the substrate or substrate holder is at a low or very low pressure. The latter is the case for, for instance, extreme ultraviolet (EUV) radiation lithography. In this case, it may not be possible to develop a sufficiently large pressure difference across the substrate (or substrate holder) to clamp it. Electrostatic clamping can be used in vacuum (or in other circumstances). In electrostatic clamping, an electrode provided on the substrate table and/or substrate holder is raised to a relatively high potential, for instance in the range of 10 to 5000 V. Electrostatic forces attract the substrate. Thus, another purpose of the burls is to space the substrate, substrate holder and substrate table apart in order to enable electrostatic clamping.

US patent number 9,939,737 discloses an electrostatic clamp comprising an electrode, a layer of resistive material located on the electrode, and a layer of dielectric located on the resistive material, wherein the electrostatic clamp further comprises burls which project from the layer of dielectric.

Although the electrostatic clamp of US-9939737-B2 generally works well, and has been successfully applied in EUV lithography machines, the fabrication process of the substrate holder is relatively elaborate, time intensive, and prone to errors and failures in one of the many steps of the process. As a result, the clamp itself is relatively expensive to make.

It is an object of at least one embodiment of at least one aspect of the present invention to obviate at least some disadvantages of, or to at least improve over the prior art.

### SUMMARY

The disclosure provides a system for holding an object in a semiconductor manufacturing process, the system comprising:
at least one pad of dry adhesive material, the material having a structured surface, the surface having a structuring comprising a plurality of projections each having a stem and an end face facing away from the surface, said end face of the projections being adapted to grip the object,
the system being adapted to release the object by movement of the object with respect to the dry adhesive material or vice versa.

In an embodiment, the system comprises a wafer handler, the wafer handler having one or more fingers arranged to move under the object, each of the one or more fingers being provided with one or more pads of dry adhesive material.

In an embodiment, the system comprises a substrate support system, the substrate support system being provided with one or more pads of the dry adhesive material for holding the object.

In an embodiment, the substrate support system comprises a substrate table (WT), the substrate table having a top side being provided with a number of first burls, a number of first retractable elements being arranged between the first burls, each of the first retractable elements being provided with a respective pad of dry adhesive material, the end faces of the projections of the dry adhesive material on the first retractable elements being arranged substantially in a first plane adapted for holding a substrate, wherein the first retractable elements are adapted to move the first plane between a handling position, wherein the first plane is remote from end faces of the first burls, and a clamping position, wherein the first plane is substantially level with or below the end faces of the first burls.

In an embodiment, the substrate table has a bottom side provided with a number of second burls, a number of second retractable elements being arranged between the second burls, each of the second retractable elements being provided with a respective pad of dry adhesive material,
the end faces of the projections of the dry adhesive material on the second retractable elements substantially arranged in a second plane adapted for engaging a positioning module, wherein the second retractable elements are adapted to move the second plane between a disengagement position, wherein the second plane is remote from end faces of the second burls, and a clamping position, wherein the second plane is substantially level with or above the end faces of the second burls.

In an embodiment, the system comprises a positioning module arranged to support and position the substrate table, the substrate table having a bottom side provided with a number of second burls, the positioning module being provided with a number of third retractable elements being arranged on a surface of the positioning module facing the substrate table, the third retractable elements being provided with a respective pad of dry adhesive material, the end faces of the dry adhesive material on the third retractable elements being substantially arranged in a third plane adapted to engage the bottom side of the substrate table,
wherein the third retractable elements are adapted to move the third plane between an engagement position, wherein the third plane is remote from the positioning module, and a retracted position, wherein the third plane is retracted towards the positioning module.

In an embodiment, the first burls and/or the second burls have a height in the range of about 1 µm to 2 mm, preferably between 1 and 250 µm.

In an embodiment, the first retractable elements, second retractable elements, and/or third retractable elements comprising an element selected from: Piezo electric, electromagnetic, Lorentz, air pressure actuated, Electrostatic, Bi-metal, Double stability mechanism and Mechanically actuated

According to another aspect, the disclosure provides a lithographic system comprising a system as described above.

According to yet another aspect, the disclosure provides a method of holding an object in a semiconductor manufacturing process, the method comprising the steps of:
providing at least one pad of dry adhesive material with a structured surface, the surface having a structuring comprising a multiplicity of first projections which at least each have a stem and comprise an end face facing away from the surface,
gripping the object using said end face of the projections, and
releasing the object by movement of the object with respect to the dry adhesive material or vice versa.

In an embodiment, the method comprises the steps of:
providing each of one or more fingers of a wafer handler with one or more of the at least one pad of dry adhesive material;
gripping the object by moving the one or more fingers to a position under the object and subsequently moving the fingers upward until the end faces engage the object;
moving the object using the wafer handler from a first storage location to an exposure location;
releasing the fingers from the object;
exposing the object to radiation in a photolithography process;
gripping the object by moving the one or more fingers to a position under the object and subsequently moving the fingers upward until the end faces engage the object;
moving the object using the wafer handler from the exposure location to a second storage location.

In an embodiment, the method comprises the step of providing a substrate support system with at least one of the at least one pad of dry adhesive material for holding the object.

In an embodiment, the substrate support system comprises a substrate table, the substrate table having a top side being provided with a number of first burls, a number of first retractable elements being arranged between the first burls, each of the first retractable elements being provided with a respective pad of dry adhesive material, the end faces of the dry adhesive material on the first retractable elements being arranged substantially in a first plane adapted for holding a substrate,
the method comprising the step of:
controlling the first retractable elements to move the first plane between a handling position, wherein the first plane is remote from end faces of the first burls, and a clamping position, wherein the first plane is substantially level with or below the end faces of the first burls.

In an embodiment, the substrate table has a bottom side provided with a number of second burls, a number of second retractable elements being arranged between the second burls, each of the second retractable elements being provided with a respective pad of dry adhesive material, the end faces of the dry adhesive material on the second retractable elements being substantially arranged in a second plane adapted for engaging a positioning module,
the method comprising the step of controlling the second retractable elements to move the second plane between a disengagement position, wherein the second plane is remote from end faces of the second burls, and a clamping position, wherein the second plane is substantially level with or above the end faces of the second burls.

In an embodiment, the system comprises a positioning module arranged to support and position the substrate table, the substrate table having a bottom side provided with a number of second burls, the positioning module being provided with a number of third retractable elements being arranged on a surface of the positioning module facing the substrate table, the third retractable elements being provided with a respective pad of dry adhesive material, the end faces of the dry adhesive material on the third retractable elements being substantially arranged in a third plane adapted to engage the bottom side of the substrate table,
the method comprising the step of controlling the third retractable elements to move the third plane between an engagement position, wherein the third plane is remote from the positioning module, and a retracted position, wherein the third plane is retracted towards the positioning module.

The system and method of the present disclosure provide a relatively simple, cost effective and durable alternative for holding objects, such as wafers and reticles, in a semiconductor manufacturing process.

Added advantages for lithography using deep ultraviolet (DUV) radiation include obviating vacuum hosing and routing. The latter allows simplification of cables and weight thereof. The system and method may also obviate the pneumatic unit in the positioning module, saving weight and costs.

Added advantages for lithography using extreme ultraviolet (EUV) radiation relate to obviating electrostatic cables. The latter generally are complex and expensive, and require vacuum feedthroughs, High Voltage and related equipment and shielding, etc. For EUV, the system adds the benefit of supply chain diversification by providing an alternative to electrostatic clamping.

Added advantages for lithography using either DUV or EUV relate to utilizing dry adhesive or Gecko material for warped wafer clamping, i.e. clamping of insufficiently flat wafers. The method and system of the disclosure allows a single method applicable for both DUV and EUV machines, simplifying supply chains and providing related cost benefits.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a schematic illustration in cross section of a prior art material indicating adhesion to a surface;
- Figure 3 depicts a schematic illustration in cross section of the prior art of Figure 3, indicating detachment from said surface;
- Figure 4 schematically depicts a cross section of a substrate handler;
- Figure 5 schematically depicts a cross section of a substrate support on a positioning module;
- Figures 6 to 9 schematically depict steps in an embodiment of a method of clamping the object to a support structure; and
- Figures 10 to 12 schematically depict a cross section of various embodiments of a retractable element.

### DETAILED DESCRIPTION

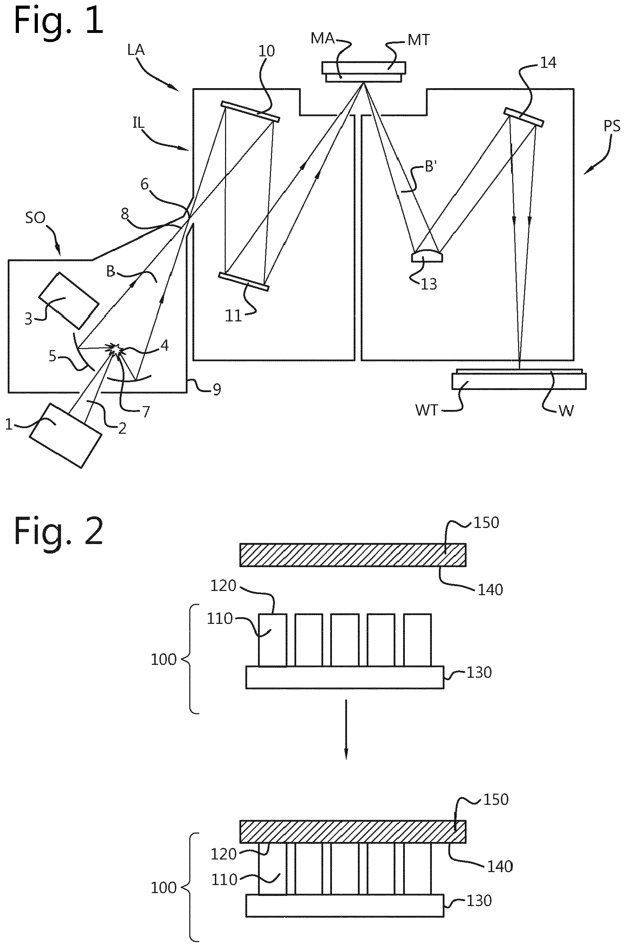

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The company Innocise [Saarbrücken, Germany] has started to market nature-based materials allowing to grip substrates. Their current slogan is "Green and efficient. We turn robots into geckos." According to the company website, "INNOCISE develops bio-inspired gripping solutions for challenging automation processes. Based on Gecomer^{®} Technology, INNOCISE produces special polymers capable of handling components from several meters to less than 10 microns with the highest precision and maximum efficiency. Inspired by the so-called Gecko effect, picking and placing of the component works without external energy and without any residues - by using van der Waals interactions."

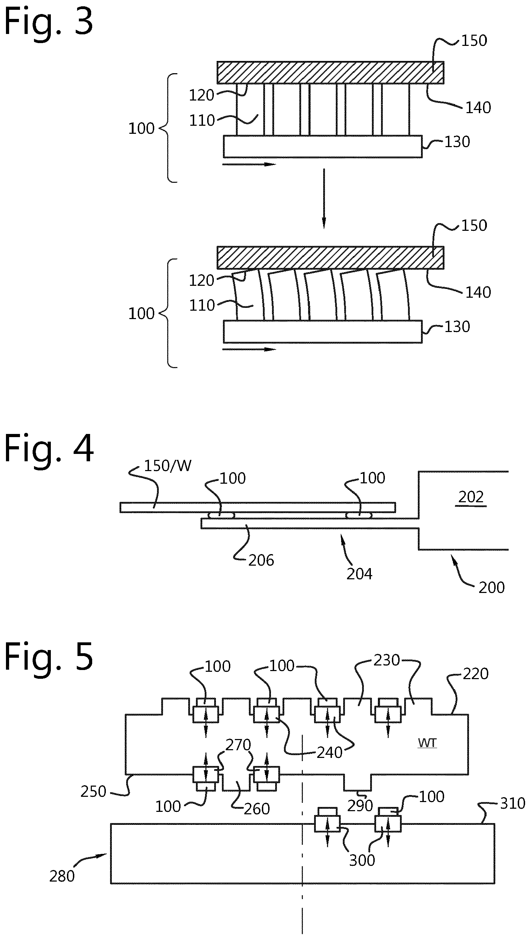

Details regarding the materials made by Innocise, and the methods to make the materials, is disclosed in, for instance, published patent documents including US2021062839, US2021071046, and US2006005362. The information of these patent publications is included herein by reference, in particular to reference fabrication methods and various forms, shapes, chemical compositions etc. of these materials. For ease of reference, an excerpt from US2021062839 is included herein with respect to Figures 2 and 3 to indicate how the material can adhere to a surface, and how said surface can subsequently be released.

Other companies and universities have developed similar nature based solutions for gripping. For instance, Georgia Institute of Technology has published the article "Surfaces that grip like gecko feet could be easily mass-produced." ScienceDaily, 7 May 2020. The University of Massachusetts Amherst claims the trade mark GeckSkin^{™} for a material having some properties for gripping similar to Gecko feet.

These materials may be referred to as, for instance, dry adhesive or Gecko material. The development of electron microscopy in the 1950s revealed for the first time the micro-structure of the setae on a foot of a gecko. In 2000, a research team led by biologists Kellar Autumn of Lewis & Clark College in Portland, Oregon, and Robert Full at the University of California at Berkeley showed that the underside of a gecko toe typically bears a series of ridges, which are covered with uniform ranks of setae, and each seta further divides into hundreds of split ends and flat tips called spatulas. A single seta of the tokay gecko is roughly 110 micrometers long and 4.2 micrometers wide. Each of a seta's branches ends in a thin, triangular spatula connected at its apex. The end is about 0.2 micrometers long and 0.2 micrometers wide. The adhesion between gecko's foot and a respective surface is the result of the Van der Waals force between each seta and the surface molecules. A single seta can generate up to 200 µN of force. There are about 14,400 setae per square millimeter on the foot of a tokay gecko, which leads to a total number of about 3,268,800 setae on a tokay gecko's two front feet. The intermolecular force, or the van der Waals force in this case, between two surfaces is greatly dominated by the number of contacts. This is exactly the reason why the gecko's feet can generate extraordinary adhesion force to different kinds of surfaces. The combined effect of millions of spatulae provides an adhesive force many times greater than the gecko needs to hang from a ceiling by one foot. The dry adhesive material referenced above has similar structures and gripping ability.

Generally, the dry adhesive material 100 is provided with a structured surface. The surface has a structuring comprising a multiplicity of projections 110 (pillars) which have a stem and comprise an end face 120 which faces away from the surface. It is with said end face that the projections come into contact with a surface 140 of an adhering object 150. In combination, the projections 110 imitate the adhesive force of Gecko feet.

Figure 2 shows how the material 100 as mentioned engaging the surface 140 of the object 150. Here, the end faces 120 of the first projections 110 come into contact with the surface 140 and said end faces and said surface adhere to one another. The object 150 is then bound to the Gecko material 100.

Figure 3 shows a sequence of steps to detach the object 150 from the pad of dry adhesive material 100. To this end, the material 100 is moved laterally (arrow at the top) relative to the object 150. As a result, stress(es) arise(s) in the first projections 110 and the projections 110 bend. This leads to a partial detachment of the end faces 120 from the surface 140 of the object 150. This reduces the contacting area of the end faces 120, and the adhesive force with which the object 150 is bound to the dry adhesive material 100 is reduced, possibly until the object 150 has completely disengaged.

Another option to disengage the object 150 from the material 100 is to pull the object away from the material with a force exceeding the gripping force of the Van Der Waals forces of all projections 110 combined. The latter manner would be suitable for objects having a sufficient resistance to bending to avoid bending or otherwise changing the shape of the object.

The present disclosure proposes various uses of the dry adhesive material 100 in a semiconductor manufacturing process. For instance, a substrate support system may be provided with a number of pads of the dry adhesive material 100 for holding and releasing respective objects. The substrate support system herein may include, for instance, one or more of a wafer handler, a reticle handler, a reticle table, a sensor holder, a cleaning disk holder, a substrate table WT, and a positioning module for the substrate table.

Figure 4 shows a machine 200 generally referred to as wafer handler or wafer gripper. Such machines are marketed by, for instance, VDL Groep [Eindhover, Netherlands] and Hine Automation [Florida, USA] or Semiconductor Production Systems [SPS-Europe B.V., NL]. The wafer handler may comprise a body 202 and one or more movable arms 204. The arms 204 may typically comprise an end section 206 provided with one or more fingers. The body is typically provided with one or more motors adapted to control movement of the arms 204 and the related fingers 206. The fingers typically are adapted to move from a neutral position, away from the object 150 or at least disengaged therefrom, to an engagement position gripping the object.

According to the disclosure, the arms 204 and/or fingers 206 may be provided with one or more pads of dry adhesive material 100 as exemplified in Figures 2 and 3. The first projections 110 of the dry adhesive material enable the arms and its fingers to engage the object 150, i.e. grip the object. Gripping the object allows the handler 200 to move the object, which may be a substrate, reticle or wafer W used in the lithographic apparatus LA of Fig. 1, from a first storage location to an exposure location. The exposure location of the wafer W is for instance on the wafer table WT. A reticle would be moved to a position in the mask assembly MA on the mask table MT. After exposure, the handler 200 can move the object from the exposure location to a second storage position. Obviously, the handler 200 may hold and transport substrates from any one location to any other location, as per design and operating parameters.

Generally referring to Figure 5, the substrate table WT may comprise a top surface 220 provided with projections or burls 230 configured to support the substrate. The substrate may be a wafer or reticle in a semiconductor production process. The top surfaces of the first burls 230 are designed to, in conjunction, form a substantially flat and planar support for the substrate W, which itself is also flat. As mentioned, the burls may extend from the upper surface 220 of the wafer table WT and define a plane to support the substrate W during exposure.

A number of retractable elements 240 may be arranged between the first burls 230. The first retractable elements 240 may on one side be connected to the top surface 220 of the substrate holder WT. On an opposite side, facing the substrate W, the first retractable elements may be provided with a pad of dry adhesive material 100. Said dry adhesive material has the first projections 110 thereof facing outward, away from the table WT. Thus, the end faces 120 of the first projections 110 can engage with and grip an object 150, such as the wafer W.

A bottom surface 250 of the wafer table WT may be provided with a number of projections 260. In an embodiment, shown on the left side of Figure 5, a number of second retractable elements 270 may be arranged between the projections or second burls 260. Each of the second retractable elements 270 can be provided with a pad of dry adhesive material 100. Herein, the end faces 120 of the dry adhesive material on the second retractable elements 270 in conjunction form a plane. I.e., said end faces 120 are substantially arranged in a second plane adapted for engaging an object. As indicated in Fig. 5, said object may be a positioning module 280. The positioning module may be a moveable element connected to, or provided with, suitable motors or positioning elements. Thus, the positioning module allows to position the substrate table WT with respect to the incident radiation (see Figure 1), while allowing replacement of the substrate table. The second retractable elements 270 are adapted to move the second plane between a disengagement position, wherein the second plane is remote from end faces 290 of the second burls 260, and a clamping position, wherein the second plane is substantially level with or above the end faces 290 of the second burls 260.

In another embodiment, shown on the right side of Figure 5, the positioning module 280 may be provided with a number of third retractable elements 300 arranged on a surface 310 of the positioning module facing the substrate table WT. The third retractable elements 300 may be provided with a respective pad of dry adhesive material 100, the end faces 120 of said dry adhesive material on the third retractable elements 300 being substantially arranged in a third plane adapted to engage the bottom side of the substrate table WT. Herein, the third retractable elements 300 are adapted to move the third plane between an engagement position, wherein the third plane is remote from the positioning module 280, and a retracted position, wherein the third plane, together with the substrate table when it is attached to the dry adhesive material 100 on the retractable elements 300, is retracted towards the positioning module 280.

Thus, in the retracted position, the elements 270 and/or 300 pull the substrate table WT towards the positioning module 280. The end faces 290 of the protrusions 260 engage with the top surface 310 of the positioning module and are locked in position by the retracted pads of dry adhesive material 100.

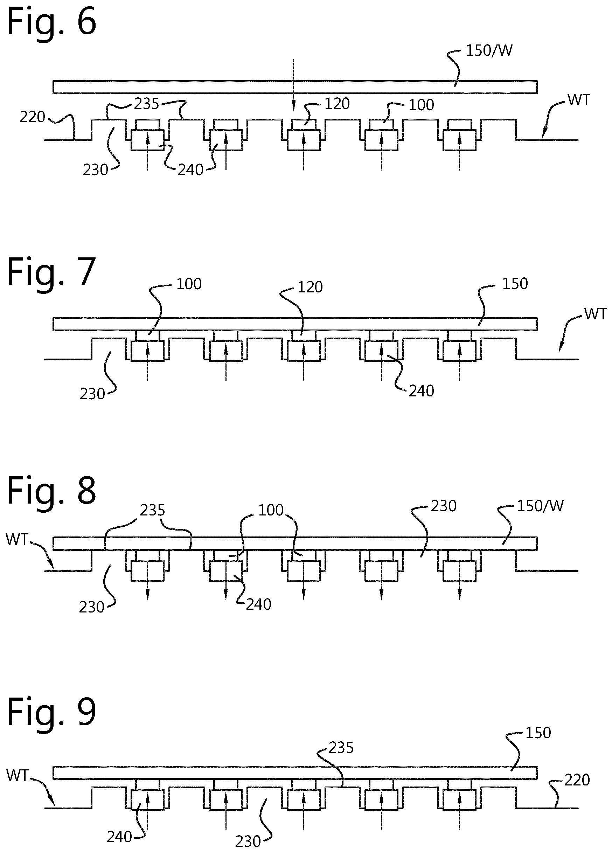

Generally referring to Figures 6 to 9, the end faces 120 of the dry adhesive material 100 on the first retractable elements 240 are arranged substantially in a plane. Said first plane is adapted for holding an object, such as the substrate W. Herein, the first retractable elements 240 are able to extend to an extended position or handling position. See Figure 7. Herein, the first elements move said first plane away from the top surface 220 of the substrate table WT. In the handling position (see Figure 7), the first plane formed by the ends 120 of the dry adhesive material 100 is remote from end faces 235 of the first burls 230.

The retractable elements 240 are also able to contract, thereby retracting the plane formed by the ends 120 of the dry adhesive material. See Figure 8. Herein, the first plane is substantially level with or below the end faces 235 of the first burls 230. As the projections 110 of the pads of dry adhesive material engage with the object 150, said projections in fact pull the object 150 onto the first burls 230. The force exerted by the retractable elements 240 can be adjusted to a predetermined setting. Thus, see Figure 8, the elements 240 allow to clamp the wafer W in a fixated position onto the substrate table WT. The position shown in Figure 8 may be referred to as a clamping position.

Please note that, although the substrate table WT is schematically shown in Figures 6 to 9 as a monolithic body, the substrate table may comprise a multitude of components. For instance, the top surface 220 and the projections or burls 230 may be comprised in a plate shaped object, referred to as 'chuck'. Said chuck may be removably connected to the substrate table, allowing replacement, refurbishment, maintenance, etc. For details, reference is made to, for instance, US9442395.

Referring to Figure 6 to 9, a method of operation may include the following steps. In a first step, see Fig. 6, a wafer handler may fetch a wafer W or other object from a first storage location, and move the wafer W to the substrate table WT. In a second step, see Figure 7, the retractable elements 240 may extend to the handling position. The wafer handler or other handling device may position the wafer W onto the ends 120 of the pads of dry adhesive material. Due to the nature and shape of the ends 120, said ends in fact grip the wafer W. In a subsequent step, see Figure 8, the retractable elements 240 contract and move to the clamping position. Herein, the substrate W is pulled onto the ends 235 of the burls 230. When in the clamping position (Fig. 8), the substrate or wafer can be exposed to radiation, in accordance with the lithography process of choice. See Figure 1 and the related description for an example. After exposure, the retractable elements 240 can extend once again, moving the substrate W to the handling position. See Figure 9. A wafer handler or other handling device can move towards the wafer W, and release the wafer from the dry adhesive material 100. Releasing the wafer can be done by applying a suitable shear force or lateral force, as explained in conjunction with Figure 3. Lateral force herein indicates a force in a direction parallel to the top surface 220 of the substrate table WT.

A gripping force can be designed within a certain range and setting, for instance, by adjusting one of more of the number of first protrusions, the shape and size of the ends 120, the number of pads of dry adhesive material 100 on the top surface 220 of the substrate table.

When a wafer is clamped using a substrate table WT provided by a Dry Adhesive, as exemplified in Figure 5, the wafer is put down on top 120 of the dry adhesion pillars 110 such that the wafer W adheres to the pillars 110. Subsequently, a mechanism 240 will bring the pillars down such that the lower surface of the wafer (referred to as backside of the wafer) touches the substrate table burls 230. A desired pre-tension is generated between the wafer W and the substrate table burls 230. Since the dry adhesive 100 typically has a predetermined elasticity, the clamping force can be controlled by, for instance, the pilar stiffness of protrusions 110 of the dry adhesive 100 and the height control of the Dry Adhesive.

Although engaging and disengaging a substrate has been described with respect to a wafer herein above, the method and system are equally suitable to grip and release other objects, including reticles or masks. To engage a reticle, dry adhesive material may be applied on a reticle table along the circumference thereof, allowing to grip the reticle only along the circumference thereof and not anywhere else.

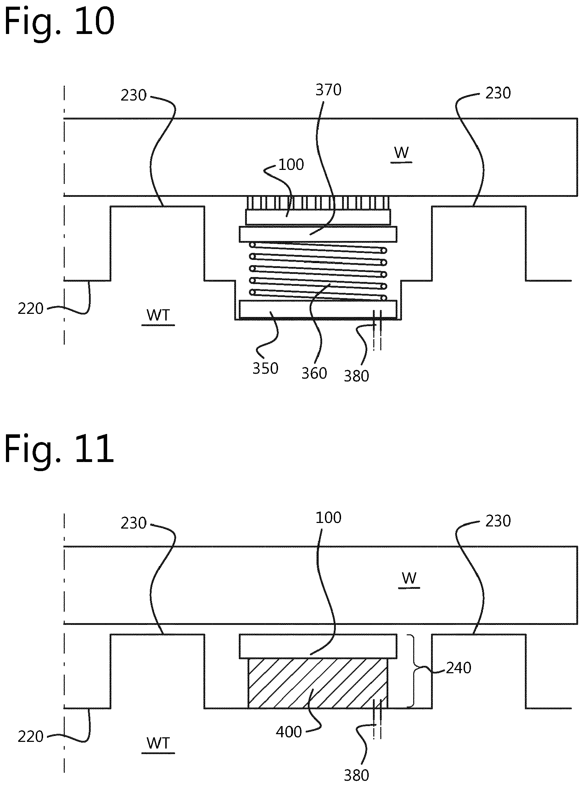

There a several possibilities for the height control using the elements 240, 270, 300. For instance, Piezo electric, electromagnetic, Lorentz, Air pressure, Electrostatic, Bi-metal, Double stability mechanism or Mechanically actuated. Exemplary embodiments are shown in Figures 10 to 12.

Figure 10 shows the retractable element 240 comprising an electro magnet 350, a spring 360, and a layer of ferromagnetic material 370. Ferromagnetic material herein may be referred to as a permanent magnet, or magnetized material. A pad of dry adhesive material 100 can be glued on top of the ferromagnetic material 370. The substrate table can be provided with electrical wiring 380 to provide electricity to the electromagnet 350.

In a first step, the electromagnet 350 can be energized by electricity via lines 380, thereby pushing the ferromagnetic material away from the surface 220 of the wafer table and moving the pad 100 to the engagement position. The engagement position allow to grip the object 150, or to disengage the object. In a second step, electrical energy to the electromagnet 350 can be interrupted. The spring 360 will pull the ferromagnetic material 370 towards the electromagnet 350, thereby moving the dry adhesive 100 to the retracted position. The retracted position may also be referred to as clamping position.

Figure 11 shows an embodiment, wherein the element 240 comprises a piezo-electric material 400. Electrical wiring 380 is connected to the piezo-electric material 400 to allow the application of an electrical potential across the height of the piezoelectric material. A pad of dry adhesive material 100 can be glued, for instance directly, on top of the piezo-electric material 400.

The piezoelectric effect results from the linear electromechanical interaction between the mechanical and electrical states in crystalline materials with no inversion symmetry. The piezoelectric effect is a reversible process: materials exhibiting the piezoelectric effect also exhibit the reverse piezoelectric effect: the internal generation of a mechanical strain resulting from an applied electrical field. For example, lead zirconate titanate crystals will generate measurable piezoelectricity when their static structure is deformed by about 0.1% of the original dimension. Conversely, those same crystals will change about 0. 1% of their static dimension when an external electric field is applied.

In a first step, there will be no electrical field across the piezoelectric material 400. I.e. there is no potential or energy applied via the electrical lines 380. The piezoelectric material 400 will be in its relaxed state, positioning the dry adhesive material 100 away from the surface 220, in the engagement position. In a second step, electrical energy can be provided via the lines 380, applying an electric field across the piezoelectric material 400. In response to the electric field, the piezoelectric material 400 will deform and will thereby move the dry adhesive 100 towards the surface 220, to the retracted position or clamping position.

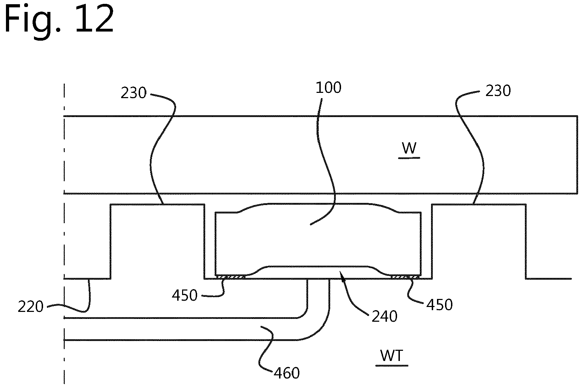

Figure 12 shows the pad of dry adhesive 100 being connected to the surface 220, for instance using adhesive 450. The substrate table may be provided with one or more conduits 460. A gas of predetermined composition can be provided to a gas chamber 470 between the pad 100 and the substrate table WT. A gas pressure in the gas chamber can be adjusted by adjusting the gas pressure Lₚ applied via the conduit 460. Typically, the gas pressure Lₚ can be adjusted between a pressurized state and a vacuum state. The pad 100 will move in conjunction with the gas pressure, between an engagement position (as shown in Figure 12) and a retracted position or clamping position (wherein the pad 100 is substantially flat, engaging the substrate table). The pressurized state may relate to a pressure Lₚ of about 1 bar. The vacuum state may relate to a pressure Lₚ allowing a suitable pressure differential across the dry adhesive material 100. The pressure Lₚ herein may be below 5 kPa, for instance in the range of about 3 kPa to 1 Pa.

The system and method of the disclosure use a dry adhesive for gripping wafers in a process for fabricating semiconductors, such as a lithography process, a semiconductor photolithograpy process, or in semiconductor measurement and inspection devices. The dry adhesive is comparable to artificial Gecko Feet. The functionality of the material 100 is based on many small pillars 110, together creating a relatively large real surface which creates a Van der Waals force with respect to the substrate. As the Van Der Waals force also functions in vacuum, the system of the disclosure is also suitable for a vacuum environment.

Placing dry adhesive between the burls 230 on top of substrate tables WT allows to clamp wafers in an EUV system, obviating electrostatic clamping. Dry adhesive typically may provide a normal force up to 10 N/cm². Thus, the system of the invention can provide a clamping force comparable to, for instance, a 1 bar pressure difference (under-pressure) for a vacuum clamp. This means that a conventional wafer table (i.e. a relatively simple wafer table as used in conventional UV and DUV lithography machines) can be used for EUV systems. The system of the invention obviates the need to electrostatic electrodes, providing sufficient clamping of the wafer. Using similar burl layout for respective lithography machines brings commonality for wafer tables, improving machine to machine overlay performance.

It will be appreciated that the term 'upper' is used in the context of the exemplary lithographic apparatus LA of Figure 1. Herein, the wafer table WT is depicted in a horizontal orientation. Although the table WT will in general be oriented horizontally, the term 'upper' is meant in respect to said wafer table, and in no way excludes a substrate support have any other, non-horizontal orientation.

In a practical embodiment, there can be many hundreds or thousands of burls, e.g. more than 10,000 or more than 40,000 burls, distributed across a substrate holder, e.g., of width (e.g., diameter) 150 mm, 200 mm, 300 mm or 450 mm. The tips of the burls have a small area, e.g. less than 1 mm². Thus the total area of all of the burls on one side of the substrate holder WT is less than about 10%, e.g. 1-3% of the total area of the total surface area of the substrate holder. Because of the burl arrangement, there is a high probability that any particle that might lie on the surface of the substrate, substrate holder or substrate table will fall between burls and will not therefore result in a deformation of the substrate or substrate holder.

The burl arrangement may form a pattern and/or may have a periodic arrangement. The burl arrangement can be regular or can vary as desired to provide appropriate distribution of force on the substrate W and substrate table WT. The burls can have any shape in plan but are commonly circular in plan. The burls can have the same shape and dimensions throughout their height but are commonly tapered. The distance that the burls project from the top surface 220 of the substrate holder WT is from about 1 mm to about 5 mm, for instance from about 5 mm to about 250 mm. The thickness of the main body of the substrate holder WT can be in the range of about 1 mm to about 50 mm, desirably in the range of about 5 mm to 20 mm, typically 10 mm

Embodiments of the present disclosure provide several advantages in the handling and clamping of substrates. For instance compared to electrostatic clamps, the system and method of the disclosure lead to significantly reduced costs to fabricate and operate a clamp. The systems provide higher yield compared to electrostatic clamps, meaning improved reliability and accuracy overall. In addition, costs are lower as the infrastructure required to allow the devices to function is less complex. Infrastructure required for electrostatic clamps herein relates to, for instance, cables, power amplifiers, safety measures, etc. Also, the lifetime of the system of the disclosure is relatively long, as the dry adhesive material 100 can be finetuned for longevity. Summarizing, both capital expenditure and operational expenditure are lower, compared to conventional systems.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A system for holding an object in a semiconductor manufacturing process, the system comprising:
at least one pad of dry adhesive material (100), the material having a structured surface, the surface having a structuring comprising a plurality of projections (110) each having a stem and an end face (120) facing away from the surface, said end face of the projections being adapted to grip the object (150),
the system being adapted to release the object by movement of the object (150) with respect to the dry adhesive material (100) or vice versa.

2. The system of claim 1, comprising a wafer handler (200), the wafer handler having one or more fingers arranged to move under the object, each of the one or more fingers being provided with one or more pads of dry adhesive material (100).

3. The system of claim 1 or 2, comprising a substrate support system, the substrate support system being provided with one or more pads of the dry adhesive material (100) for holding the object.

4. The system of claim 3, the substrate support system comprising a substrate table (WT), the substrate table having a top side (220) being provided with a number of first burls (230), a number of first retractable elements (240) being arranged between the first burls, each of the first retractable elements being provided with a respective pad of dry adhesive material (100), the end faces of the projections of the dry adhesive material (100) on the first retractable elements (240) being arranged substantially in a first plane adapted for holding a substrate (150, W), wherein the first retractable elements are adapted to move the first plane between a handling position, wherein the first plane is remote from end faces of the first burls (230), and a clamping position, wherein the first plane is substantially level with or below the end faces of the first burls.

5. The system of claim 4, the substrate table having a bottom side provided with a number of second burls (260), a number of second retractable elements (270) being arranged between the second burls, each of the second retractable elements being provided with a respective pad of dry adhesive material (100),
the end faces of the projections of the dry adhesive material on the second retractable elements substantially arranged in a second plane adapted for engaging a positioning module (280), wherein the second retractable elements are adapted to move the second plane between a disengagement position, wherein the second plane is remote from end faces (290) of the second burls (260), and a clamping position, wherein the second plane is substantially level with or above the end faces of the second burls.

6. The system of claim 4, comprising a positioning module arranged to support and position the substrate table (WT), the substrate table having a bottom side (250) provided with a number of second burls (260), the positioning module (280) being provided with a number of third retractable elements (300) being arranged on a surface (310) of the positioning module facing the substrate table, the third retractable elements being provided with a respective pad of dry adhesive material (100), the end faces of the dry adhesive material on the third retractable elements being substantially arranged in a third plane adapted to engage the bottom side (250) of the substrate table (WT),
wherein the third retractable elements (300) are adapted to move the third plane between an engagement position, wherein the third plane is remote from the positioning module (280), and a retracted position, wherein the third plane is retracted towards the positioning module (280).

7. The system of any one of claims 4 to 6, wherein the first burls (230) and/or the second burls (260) have a height in the range of about 1 µm to 2 mm, preferably between 1 and 250 µm.

8. The system of any one of claims 1 to 7, the first retractable elements (240), second retractable elements (270), and/or third retractable elements (300) comprising an element selected from: Piezo electric, electromagnetic, Lorentz, air pressure actuated, Electrostatic, Bi-metal, Double stability mechanism and Mechanically actuated

9. A lithographic system comprising a system according to any one of claims 1 to 8.

10. A method of holding an object in a semiconductor manufacturing process, the method comprising the steps of:
providing at least one pad of dry adhesive material (100) with a structured surface, the surface having a structuring comprising a multiplicity of first projections (110) which at least each have a stem and comprise an end face facing away from the surface,
gripping the object (150) using said end face of the projections, and
releasing the object by movement of the object (150) with respect to the dry adhesive material (100) or vice versa.

11. The method of claim 10, comprising the steps of:
providing each of one or more fingers of a wafer handler (200) with one or more of the at least one pad of dry adhesive material (100);
gripping the object by moving the one or more fingers to a position under the object and subsequently moving the fingers upward until the end faces engage the object;
moving the object using the wafer handler from a first storage location to an exposure location;
releasing the fingers from the object;
exposing the object to radiation in a photolithography process;
gripping the object by moving the one or more fingers to a position under the object and subsequently moving the fingers upward until the end faces engage the object;
moving the object using the wafer handler from the exposure location to a second storage location.

12. The method of claim 10 or 11, comprising the step of providing a substrate support system with at least one of the at least one pad of dry adhesive material (100) for holding the object.

13. The method of claim 12, the substrate support system comprising a substrate table, the substrate table having a top side being provided with a number of first burls (230), a number of first retractable elements being arranged between the first burls, each of the first retractable elements being provided with a respective pad of dry adhesive material (100), the end faces of the dry adhesive material on the first retractable elements being arranged substantially in a first plane adapted for holding a substrate,
the method comprising the step of:
controlling the first retractable elements to move the first plane between a handling position, wherein the first plane is remote from end faces of the first burls (230), and a clamping position, wherein the first plane is substantially level with or below the end faces of the first burls.

14. The method of claim 13, the substrate table having a bottom side provided with a number of second burls (260), a number of second retractable elements (270) being arranged between the second burls, each of the second retractable elements being provided with a respective pad of dry adhesive material (100), the end faces of the dry adhesive material on the second retractable elements (270) being substantially arranged in a second plane adapted for engaging a positioning module (280),
the method comprising the step of controlling the second retractable elements (270) to move the second plane between a disengagement position, wherein the second plane is remote from end faces of the second burls (260), and a clamping position, wherein the second plane is substantially level with or above the end faces of the second burls.

15. The system of claim 13, comprising a positioning module (280) arranged to support and position the substrate table (WT), the substrate table having a bottom side (250) provided with a number of second burls (260), the positioning module being provided with a number of third retractable elements (300) being arranged on a surface (310) of the positioning module facing the substrate table, the third retractable elements being provided with a respective pad of dry adhesive material (100), the end faces of the dry adhesive material on the third retractable elements (300) being substantially arranged in a third plane adapted to engage the bottom side (250) of the substrate table (WT),
the method comprising the step of controlling the third retractable elements (300) to move the third plane between an engagement position, wherein the third plane is remote from the positioning module (280), and a retracted position, wherein the third plane is retracted towards the positioning module.
